(19) Europäisches Patentamt
European Patent Office
Office européen des brevets

(11) EP 0 497 306 B1

(12) **EUROPEAN PATENT SPECIFICATION**

(45) Date of publication and mention of the grant of the patent:
**21.11.2001 Bulletin 2001/47**

(51) Int Cl.7: **H01L 21/312**, H01L 21/768, H01L 21/316

(21) Application number: **92101456.9**

(22) Date of filing: **29.01.1992**

(54) **Insulating film manufacturing method for a semiconductor device**

Verfahren zum Herstellen isolierenden Films für Halbleitervorrichtung

Procédé de fabrication de couche isolante pour dispositif semi-conducteur

(84) Designated Contracting States:
**DE FR GB IT NL**

(30) Priority: **31.01.1991 JP 3184691**

(43) Date of publication of application:
**05.08.1992 Bulletin 1992/32**

(73) Proprietor: **TEXAS INSTRUMENTS INCORPORATED**
**Dallas Texas 75265 (US)**

(72) Inventors:
- **Kobayashi, Shoji**
**Kita-katsushika-gun Saitama-ken (JP)**
- **Yoshikawa, Mitsuru**
**Ibaraki-ken (JP)**

(74) Representative:
**Schwepfinger, Karl-Heinz, Dipl.-Ing. et al**
**Prinz & Partner GbR**
**Manzingerweg 7**
**81241 München (DE)**

(56) References cited:
**EP-A- 0 232 748**
**EP-A- 0 388 563**
**DE-A- 3 915 337**
**GB-A- 2 191 338**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

### Field of the Invention

The present invention pertains to a method for manufacturing a semiconductor device, and pertains in particular to a method by which an insulator is filled into the contact holes or via contact holes inside a semiconductor device.

### Prior Art

Conventionally, the procedures shown in Figure 5 (a) and (b) are used to flatten interlayer insulating films in order to form multilayer wiring such as TLM (triple level metal).

In Figure 5 (a), a contact hole (21) is connected to a diffusion layer (2) formed on a semiconductor substrate (1), and aluminum (Al) wiring (3) is formed on top of an $SiO_2$ film (9), etc., which is formed on top of the semiconductor substrate (1).

This Al film (3) is also formed (adhered) to the inner walls of the contact hole (21) to be electrically connected to the diffusion layer (2) via the contact hole (21).

Once the desired patterning has been formed, the top of the Al wiring (3) is coated with a vapor phase growth insulating film (4), on top of which a resistor film (5) is then formed.

Next, as shown in Figure 5 (b), flattening (resistor etching) is carried out by an etching method such that the resistor film (5) and vapor phase growth insulating film (4) will have the same etching rate.

A number of layers may be formed on top of the etched vapor phase growth insulating film (4). For the via contact holes used for making interlayer connections in this case, the procedures of Al wiring formation, vapor phase growth insulating film formation, resistor film formation, and resistor etching are carried out in the same manner as for the contact hole.

When the vapor phase growth insulating film (4) is formed on the contact hole (21) as shown in Figures 5 (a) and (b), air holes (7) will often form, thus lowering reliability. In particular, if the diameter of the contact hole (21) is less than 1.2 μm, then the air holes (7) will be exposed when resistor etching is carried out, thus creating empty spots (depressions), which are problematic.

In order to solve this problem, there have been attempts to use methods in which spion [sic; spin-on] glass (SOG), an insulating film formation solution containing $SiO_2$, is utilized.

GB-A-2 191 338 discloses a planarization process for a double metal VLSI technology. To compensate for an irregular surface topology encountered in a dielectric medium between the two metals, a CVD dielectric layer and a glass layer are first deposited above the first metal. Then an etch-back process is used to uniformly etch back the CVD dielectric and the glass layers at the same rate, leaving a planarized surface.

A further example of this will be described with reference to Figure 6 (a) and (b) . The numbers (1, 2, 3, 4, 7, and 9) refer to the same items as those shown in Figure 5 (a) and (b).

Figure 6 (a) shows an example in which SOG with a high concentration of $SiO_2$ solid components is applied on top of the vapor phase growth insulating film (4) to form an SOG applied insulating film (6a). In addition, Figure 6 (b) shows an example in which SOG with a low concentration of $SiO_2$ solid components is applied to the vapor phase growth insulating film (4) to form an SOG applied insulating film (6b).

### Problems for the Invention to Solve

Due to the high concentration of $SiO_2$ solid components, the formation of an insulating film using the SOG applied insulating film (6a) shown in Figure 6 (a) often results in the formation of air holes (7), as when the insulating film is formed inside the contact hole (21) using the vapor phase growth insulating film (4) shown in Figure 5 (a).

When the insulating film is formed using the SOG application insulating film (6b) shown in Figure 6 (b), although the SOG fills the gaps in the vapor phase growth insulating film (4) on the inner walls of the contact hole (21), since the concentration of $SiO_2$ solid components is low, empty spaces (depressions) (8) are formed on top of the contact hole (21).

The formation of air holes (7) shown in Figure 6 (a), and the formation of depressions (8) shown in Figure 6 (b) are problematic in causing cracks and line breaks in the subsequent procedures.

The example described above was related to contact holes, but the same type of problems occur when the insulating film is formed with a via contact hole formed on the upper layer.

Thus, the present invention has the objective of forming a flat insulating film with small depressions on the contact hole or via contact hole, without creating air holes in the insulating film area on the contact hole or via contact hole.

Means for Solving the Problems

In order to solve the aforementioned problems, with the present invention, an insulating film formation solution having the desired concentration of solid components, such as an SOG solution, is applied and hardened a number of times, thereby filling the contact hole area or via contact hole area of the semiconductor device with the insulator, without creating air holes inside the contact hole or via contact hole. The insulating film formation solution on the lower layer is semi-hardened after being applied so that the insulation on the lower level will not be affected by the following insulation solution, which is used to form the upper level.
Specifically, the present invention offers a method of making a semiconductor device as defined in claim 1.

Embodiments

Figure 1 shows a cross section of the first application example of the present invention, in which an SOG insulating film is formed on the contact hole area. Figure 2 shows an enlarged view of the contact hole area.
The contact hole (21), which is connected to the diffusion layer (2) formed inside the semiconductor substrate (1), is formed through an $SiO_2$ film (9). The Al wiring (3) is formed and adhered to the upper surface of the $SiO_2$ film (9) and the inner walls of the contact hole (21). After the desired patterning has been carried out, the vapor phase growth insulating film (4) is formed.
In the present application example, the inner diameter Dc of the contact hole (21) is set to 1.7 µm (17000 Å); and the depth Hc of the contact hole (21) is set to 1.2 µm (12000 Å). The air hole diameter D4 of the vapor phase growth insulating film (4) inside the contact holes (21) is 0.5 µm (5000 Å); and the depth H4 of the vapor phase growth insulating film (4) from the top of the Al wiring (3) to the bottom of the contact hole (21) is 2.1 µm (21000 Å). The thickness H3 of the Al wiring (3) is 0.8 µm (8000 Å).
Under the aforementioned conditions, the lower SOG applied film (10) is first formed, after which the upper SOG applied film (11) is formed, thereby filling the empty space in the contact hole (21) through the top of the vapor phase growth insulating film (4).

(1-1) Application of lower SOG applied film (10)

a) In a static state, 9.5 wt% of the SOG solution is applied through the top of the vapor phase growth insulating film (4).
b) Rotation is carried out for approximately one second at a low speed, such as 700 RPMs.
c) Rotation is carried out for approximately 30 seconds at a high speed, such as 4000 RPMs.

(1-2) First baking procedure

a) Bake for two minutes on a hot plate at 100°C.
b) Bake for two minutes on a hot plate at 180°C.
c) Bake for two minutes on a hot plate at 260°C.

(1-3) Cooling

Cool for two minutes on a cooling plate at a normal temperature, such as 23°C.
The lower SOG applied film (10) is thus hardened (thermally hardened). This hardening process is carried out in order to prevent the lower SOG applied film (11) [sic (10)], already formed, from being affected during the following procedure, in which the upper SOG applied film (11) is formed.
The process for hardening the SOG solution by baking can be expressed in the following chemical formula. "R" denotes an alkyl group in the chemical formula.

(Chemical formula 1) [see page 15]

(2-1) Application of upper SOG applied film (11)

a) In the still state, 12 wt% of the SOG solution is applied through the vapor phase growth insulating film (4).
b) Rotation at low speed in the same manner as in (1-1) step b described above.
c) Rotation at high speed in the same manner as in (1-1) step c described above.

(2-2) Second baking procedure

The baking procedure is the same as in steps a-c in (1-2) described above.

(3) Main hardening procedure

Heat at 250°C for 30 minutes, then at 400°C for 60 minutes, in a low pressure nitrogen atmosphere.

As shown in Figures 1 and 2, with the aforementioned procedures, after the Al wiring (3) and vapor phase growth insulating film (4) are adhered to the inner walls of the contact hole (21), the diameter is D4 = 0.5 μm and depth is H4 = 2.1 μm. However, the lower SOG applied film (10) is properly filled into the space of the contact hole (21) without creating air holes, and the upper SOG applied film (11), which is formed on top of the lower SOG applied film (10), is formed to be almost completely flat on the upper surface of the vapor phase growth insulating film (4).

Although there is a slight depression (empty space), the depth d is in the range of 1-0.3 μm.

As described above, when the lower SOG applied film (10) and the upper SOG applied film (11) are formed together in two layers, in order to prevent the occurrence of air holes, it is best that the concentration of solid components in the SOG solution of the lower layer SOG applied film (10) be set to 9.5 wt%, which is lower than the 12 wt% concentration of solid components in the SOG solution of the upper layer SOG applied film (11), in the aforementioned manner.

In addition, experiments have confirmed that it is possible to obtain the same effects as those described above, even if the lower SOG applied film (10) and upper SOG applied film (11) are set to have the same SOG concentration, without changing the SOG concentrations of the lower level and upper level in the manner of the aforementioned application example. According to the experiments, the concentration of solid components in the SOG solution should be set in the range of 9.5 wt% to 12 wt%, and when the SOG solutions form a single film on a flat substrate, the thickness of the SOG insulating film should be in the range of 200-400 nm (2000-4000 Å).

Table I on page 14 shows the experimental data obtained under a variety of conditions when the lower layer SOG applied film (10) and upper layer SOG applied film (11) were set to have the same SOG solution concentration.

(Table I)

The depth, height, and inner diameter units in Table I are in μm.

In addition, Figure 3 shows a features graph which illustrates the relation between the thickness of the upper SOG applied film (11) and the degree of flatness P on the surface of the upper SOG applied film (11). The horizontal axis represents the thickness of the SOG film, and the vertical axis represents the degree of flatness P. In addition, the degree of flatness P is defined by the following equation.

$$P = (1 - d/1 . 2) \times 100 (\%) \qquad (1)$$

d is the depth of the depression in the upper SOG applied film (11).

In terms of manufacturing efficiency for the semiconductor device, the SOG insulating film formation procedure should be short, i.e., the number of formations should be small. Thus, it is preferable to form the lower SOG applied film (10) and upper SOG applied film (11) in two layers, as in the aforementioned application example.

However, with the present invention, it is possible to obtain the same effects as those described above even if the SOG insulating films are formed in three or more layers. In such cases, the SOG solution should have a concentration in the range of 9.5 wt% to 12 wt%, and when the SOG solutions are applied to a flat substrate to form a single film, the thickness of the SOG insulating film should be in the range of 200-400 nm (2000-4000 Å), as described above.

Figure 4 shows a cross section in which the semiconductor device shown in Figure 1 is formed in a greater number of layers.

In Figure 4, the following are sequentially laminated onto the upper surface of the upper SOG applied film (11) shown in Figure 1: a second vapor phase growth insulating film (14) layer, second Al wiring (15) layer, third vapor phase growth insulating film (18) layer, and fourth vapor phase growth insulating film (19) layer.

In addition to the contact hole (21), a via contact hole (22), which electrically connects the first Al wiring (3) layer with the second Al wiring (15) layer, and a via contact hole (23), which electrically connects the Al wiring (15) with the Al wiring (20), are formed.

The Al wiring (15) and third vapor phase growth insulating film (18) are adhered to the inner walls of the via contact hole (22), while a second lower layer (No. 2-1) SOG applied film (16), and then a second upper (No. 2-2) SOG applied film (17), are formed in the empty space. The No. 2-1 SOG applied film (16) formation method and SOG solution solid component concentration are the same as in the lower SOG applied film (10), and the No. 2-2 SOG applied film (17) formation method and SOG solution concentration are the same as in the upper SOG applied film (11).

In the same manner as the case described for Figure 1, it is possible to form not only a two layer structure, as with the No. 2-1 SOG applied film (16) and No. 2-2 SOG applied film (17), but also multiple layers consisting of three or more layers.

In addition, with the via contact hole (23), it is also possible to adhere a vapor phase growth insulating film (not shown) on top of the Al wiring (20), after which SOG films which are the same as the No. 2-1 SOG applied film (16) and No. 2-2 SOG applied film (17) are formed.

In Figure 4, it is possible to form the SOG insulation films in the same manner even if more layers are formed on top.

The present invention is not limited to the aforementioned examples, but may also be applied in a variety of altered forms and in a variety of situations.

For example, although the aforementioned application example was described in Figure 1 for a case in which the contact hole (21) is connected to the diffusion layer (2), it is not restricted to the diffusion layer (2), but may be connected to the desired conductive layer.

The case is the same with regards to using conductive interlayers other than the Al wiring (3) for connecting the via contact hole (22) of Figure 4.

In addition, the various data described above, such as the inner diameter and depth of the contact hole (21) are only examples. The present invention may be applied in the same manner to other cases, and the same results will be obtained.

The aforementioned application example was described for a case in which an SOG solution was used as the insulating film formation solution. However, in forming the insulating film of the present invention, it is possible to form the same type of insulating film using other insulating film formation solutions, such as polyimides.

## Effects of the Invention

As described above, with the present invention, insulating solutions with the prescribed concentrations of solid components are used in the contact hole area or via contact hole area, in forming an insulating film having at least two layers, such that when the solution is applied to a flat surface in a single layer, the prescribed insulating film thickness will be obtained. Thus, it is possible to form an insulating film with proper flatness in the contact hole area or via contact hole area without generating air holes in the holes, thereby making it possible to improve the production quality and yield for semiconductor devices.

## Brief Explanation of the Figures

(Figure 1)

A partial cross section of the first application example of a semiconductor device which illustrates the insulating film formation method of the present invention.

(Figure 2)

A partially enlarged view of Figure 1.

(Figure 3)

A graph of experimental results based on the application examples of the present invention.

(Figure 4)

A partial cross section of another application example of a semiconductor device which illustrates the insulating film formation method of the present invention.

(Figure 5)

A partial cross section of a semiconductor device which illustrates the insulating film formation method used in a conventional semiconductor device.

(Figure 6)

A partial cross section of a semiconductor device which illustrates another insulating film formation method used in a conventional semiconductor device.

Explanation of the Numbers

**[0060]**

1. Semiconductor substrate
2. Diffusion layer
3. Al wiring
4. Vapor phase growth insulating film
9. $SiO_2$ film
10. lower SOG applied film
11. upper SOG applied film
14. Second vapor phase growth insulating film
15. Al wiring
16. No. 2-1 SOG applied film
17. No. 2-2 SOG applied film
18 Third vapor phase growth insulating film
19. Fourth vapor phase growth insulating film
20. Al wiring
21. Contact hole
22, 23. Via contact holes

Table 1

| SOG Solution Concentration | 12 wt% | 9.5 wt% |
|---|---|---|
| Contact Hole Diameter Dc | 1.6 - 1.8 | 1.28 - 1.8 |
| Contact Hole Depth Hc | 0.9 - 1.2 | 0.8 - 1.3 |
| Inner Diameter D4 with Insulating Film (4) Adhering | 0.45 - 0.8 | 0.15 - 0.7 |
| Insulating Film (4) Depth H4 | 1.7 - 2.1 | 1.4 - 2.2 |
| Depression Depth d | 0.1 - 0.3 | 0.15 - 0.35 |

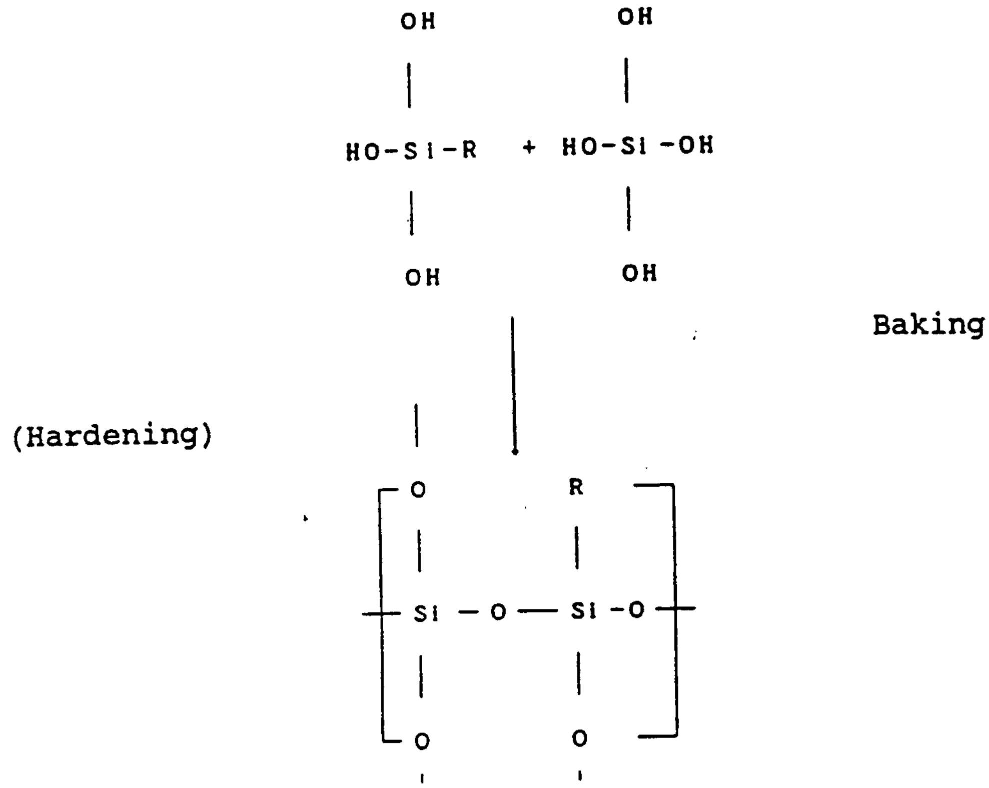


## Claims

1. A method of making a semiconductor device having a contact hole (21) extending through an insulation layer (9) to expose an electrically conductive element (2) and a patterned layer of electrically conductive material disposed on said insulation layer (9) and within the contact hole (21) to define an electrical contact member (3) covering the bottom and side walls of the contact hole (21) and in engagement with said electrically conductive element (2), wherein the contact hole (21) is only partially filled by said electrical contact member (3), the steps comprising:

    forming a second insulation layer (4) by vapor phase growth over the exposed portions of said first insulation layer (9) and said patterned electrical contact member (3) so as to provide a coating of said second insulation layer (4) thereover,

    applying a first insulating film formation solution onto the second insulation layer (4) by spinning on the first insulating film formation solution, and

    hardening the first insulation film formation solution to provide a first insulating film (10) partially filling the remainder of the unoccupied portion of the contact hole (21) within said second insulation layer (4);

    **characterized by** said first insulating film formation solution having a first solids concentration selected to be low enough that the contact hole (21) is only partially filled by the first insulating film, such that no voids (7) are entrapped therein, and by subsequently applying a second insulating film formation solution onto the first insulating film (10) by spinning on the second insulating film formation solution to fill the remainder of the unoccupied portion of the contact hole (21) with a second insulating film (11), said second insulating film formation solution having a second solids concentration selected to be low enough that the contact hole (21) is filled with the second insulating film (11) with no voids (7) entrapped therein but high enough that no depression (8) will occur in the second insulating film (11) over the contact hole (21);
    hardening the second insulating film formation solution to provide the second insulating film (11) covering said first insulating film (10) and defining a substantially flat surface spanning the contact hole (21); and
    further hardening the first and second insulating films (10, 11) by heating the semiconductor device.

**2.** A method as set forth in claim 1, further **characterized in that** first insulating film formation solution and the second insulating film formation solution are hardened by baking.

**3.** A method as set forth in any of claims 1-2, further **characterized in that** said first insulating film formation solution is a 9.5 wt. % spin-on glass solution, and
said second insulating film formation solution is a 12 wt. % spin-on glass solution.

**4.** A method as set forth in any of claims 1-3, further **characterized by** applying the first insulating film formation solution onto the second insulation layer (4) by successive spinning steps including spinning said first insulating film formation solution at a relatively low speed of rotation during a first spinning stage onto the second insulation layer (4) and thereafter further spinning said first insulating film formation solution at a relatively high speed of rotation during a second spinning stage onto the second insulation layer (4),
hardening the first insulating film formation solution by subjecting said first insulating film formation solution to a plurality of baking stages at ascending temperatures to provide a first insulating film (10) partially filling the remainder of the unoccupied portion of the contact hole (21) within said second insulation layer (4) coating the surface of said electrical contact member (3) within the contact hole (21),
cooling the first insulating film (10), subsequently applying the second insulating film formation solution onto the first insulating film (10) by successive spinning steps including spinning said second insulating film formation solution at a relatively low speed of rotation during a first spinning stage onto the first insulating film (10) and thereafter further spinning said second insulating film formation solution at a relatively high speed of rotation during a second spinning stage onto the first insulating film (10) to complete filling of the remainder of the unoccupied portion of the contact hole (21), and
hardening the second insulating film formation solution by subjecting said second insulating film formation solution to a plurality of baking stages at ascending temperatures to provide a second insulating film (11) covering said first insulating film (10) and defining a substantially flat area spanning the contact hole (21) over the top thereof.

**5.** A method as set forth in claim 4, further **characterized in that** said first spinning stage in applying each of said first and second insulating film formation solutions is carried out at a speed of 700 RPMs for approximately one second, and
said second spinning stage in applying each of said first and second insulating film formation solutions is carried out at a speed of 4000 RPMs for approximately 30 seconds.

**6.** A method as set forth in either of claims 4 or 5, further **characterized in that** said plurality of baking stages to which each of said first and second insulating film formation solutions are subjected includes respective baking stages of two minutes duration each at temperatures of 100°C, 180°C, and 260°C.

**7.** A method as set forth in any of claims 4-6, further **characterized in that** the step of further hardening the first and second insulating films (10, 11) subjects said first insulating film (10) and said second insulating film (11) to sustained heat over an extended time period and includes a first phase with heat being applied at 250°C for 30 minutes, followed by a second phase with heat being applied at 400°C for 60 minutes in a low pressure nitrogen atmosphere.

**8.** A method as set forth in any of claims 1-4, wherein said first and second insulating films (10, 11) are formed from solutions having the same solids concentrations, and have a combined thickness in the range of 200 to 400 nm (2000 to 4000 Å) on planar surfaces of said second insulating layer (4).

**Patentansprüche**

**1.** Verfahren zum Herstellen einer Halbleitervorrichtung, die ein Kontaktloch (21), das durch eine Isolierschicht (9) verläuft, um ein elektrisch leitendes Element (2) freizulegen, und eine strukturierte Schicht aus elektrisch leitendem Material aufweist, die auf der Isolierschicht (9) und in dem Kontaktloch (21) angeordnet ist, um ein elektrisches Kontaktelement (3) zu definieren, das die Unterseite und die Seitenwände des Kontaktlochs (21) bedeckt und mit dem elektrisch leitenden Element (2) in Eingriff ist, wobei das Kontaktloch (21) nur teilweise durch das elektrische Kontaktelement (3) gefüllt ist, wobei die Schritte umfassen:

Bilden einer zweiten Isolierschicht (4) durch Dampfphasenwachstum über den freiliegenden Abschnitten der ersten Isolierschicht (9) und des strukturierten elektrischen Kontaktelements (3), um so darüber eine Beschichtung aus der zweiten Isolierschicht (4) zu schaffen,

Aufbringen einer ersten Isolierfilmbildungslösung auf die zweite Isolierschicht (4) durch Schleuderauftragung der ersten Isolierfilmbildungslösung und

Härten der ersten Isolierfilmbildungslösung, um einen ersten Isolierfilm (10) zu schaffen, der den verbleibenden nicht gefüllten Abschnitt des Kontaktlochs (21) in der zweiten Isolierschicht (4) teilweise füllt;

**dadurch gekennzeichnet, daß** die erste Isolierfilmbildungslösung eine erste Feststoffkonzentration aufweist, die niedrig genug gewählt wird, damit das Kontaktloch (21) nur teilweise durch den ersten Isolierfilm gefüllt wird, derart, daß darin keine Hohlräume (7) eingeschlossen werden, und daß anschließend eine zweite Isolierfilmbildungslösung auf den ersten Isolierfilm (10) durch Schleuderauftragung der zweiten Isolierfilmbildungslösung aufgebracht wird, um den verbleibenden nicht gefüllten Abschnitt des Kontaktlochs (21) mit einem zweiten Isolierfilm (11) zu füllen, wobei die zweite Isolierfilmbildungslösung eine zweite Feststoffkonzentration besitzt, die niedrig genug gewählt wird, damit das Kontaktloch (21) mit dem zweiten Isolierfilm (11) gefüllt wird, ohne daß darin Hohlräume (7) eingeschlossen werden, jedoch hoch genug gewählt wird, damit in dem zweiten Isolierfilm (11) über dem Kontaktloch (21) keine Vertiefung (8) entsteht;

Härten der zweiten Isolierfilmbildungslösung, um den zweiten Isolierfilm (11) zu schaffen, der den ersten Isolierfilm (10) abdeckt und eine im wesentlichen ebene Oberfläche definiert, die das Kontaktloch (21) überspannt; und

weiteres Härten der ersten und zweiten Isolierfilme (10, 11) durch Erwärmen der Halbleitervorrichtung.

2. Verfahren nach Anspruch 1, ferner **dadurch gekennzeichnet, daß** die erste Isolierfilmbildungslösung und die zweite Isolierfilmbildungslösung durch Einbrennen gehärtet werden.

3. Verfahren nach einem der Ansprüche 1-2, ferner **dadurch gekennzeichnet, daß** die erste Isolierfilmbildungslösung eine 9,5 gew.-%ige Schleuderauftragungsglaslösung ist und

die zweite Isolierfilmbildungslösung eine 12 gew.-%ige Schleuderauftragungsglaslösung ist.

4. Verfahren nach einem der Ansprüche 1-3, ferner **gekennzeichnet durch** das Auftragen der ersten Isolierfilmbildungslösung auf die zweite Isolierschicht (4) **durch** aufeinanderfolgende Schleuderauftragungsschritte, die die Schleuderauftragung der ersten Isolierfilmbildungslösung mit einer verhältnismäßig niedrigen Drehzahl während einer ersten Schleuderauftragungsstufe auf die zweite Isolierschicht (4) und danach eine weitere Schleuderauftragung der ersten Isolierfilmbildungslösung mit einer verhältnismäßig hohen Drehzahl während einer zweiten Schleuderauftragungsstufe auf die zweite Isolierschicht (4) umfassen,

Härten der ersten Isolierfilmbildungslösung, wobei die erste Isolierfilmbildungslösung mehreren Einbrennstufen mit ansteigenden Temperaturen unterworfen wird, um einen ersten Isolierfilm (10) zu schaffen, der den verbleibenden nicht gefüllten Abschnitt des Kontaktlochs (21) in der zweiten Isolierschicht (4), mit der die Oberfläche des elektrischen Kontaktelements (3) in dem Kontaktloch (21) beschichtet ist, teilweise füllt,

Kühlen des ersten Isolierfilms (10), anschließendes Aufbringen der zweiten Isolierfilmbildungslösung auf den ersten Isolierfilm (10) **durch** aufeinanderfolgende Schleuderauftragungsschritte, die die Schleuderauftragung der zweiten Isolierfilmbildungslösung mit einer verhältnismäßig niedrigen Drehzahl während einer ersten Schleuderauftragungsstufe auf den ersten Isolierfilm (10) und danach eine weitere Schleuderauftragung der zweiten Isolierfilmbildungslösung mit einer verhältnismäßig hohen Drehzahl während einer zweiten Schleuderauftragungsstufe auf den ersten Isolierfilm (10) umfassen, um die Befüllung des verbleibenden nicht gefüllten Abschnitts des Kontaktlochs (21) zu vervollständigen, und

Härten der zweiten Isolierfilmbildungslösung, wobei die zweite Isolierfilmbildungslösung mehreren Einbrennstufen mit ansteigenden Temperaturen unterworfen wird, um einen zweiten Isolierfilm (11) zu schaffen, der den ersten Isolierfilm (10) abdeckt und eine im wesentlichen ebene Fläche definiert, die das Kontaktloch (21) auf dessen Oberseite überspannt.

5. Verfahren nach Anspruch 4, ferner **dadurch gekennzeichnet, daß** die erste Schleuderauftragungsstufe bei der Auftragung jeder der ersten und zweiten Isolierfilmbildungslösungen mit einer Drehzahl von 700 $min^{-1}$ etwa eine Sekunde lang ausgeführt wird und

die zweite Schleuderauftragungsstufe bei der Aufbringung jeder der ersten und zweiten Isolierfilmbildungslösungen mit einer Drehzahl von 4000 $min^{-1}$ etwa 30 Sekunden lang ausgeführt wird.

6. Verfahren nach einem der Ansprüche 4 oder 5, ferner **dadurch gekennzeichnet, daß** die mehreren Einbrennstufen, denen jede der ersten und zweiten Isolierfilmbildungslösungen unterworfen wird, jeweils Einbrennstufen mit einer Dauer von zwei Minuten bei Temperaturen von 100 °C, 180 °C bzw. 260 °C umfassen.

7. Verfahren nach einem der Ansprüche 4-6, ferner **dadurch gekennzeichnet, daß** der Schritt des weiteren Härtens der ersten und zweiten Isolierfilme (10, 11) den ersten Isolierfilm (10) und den zweiten Isolierfilm (11) über eine ausgedehnte Zeitperiode ununterbrochen Wärme aussetzt und eine erste Phase, in der bei 250 °C 30 Minuten lang erwärmt wird, gefolgt von einer zweiten Phase, in der bei 400 °C 60 Minuten lang in einer Niederdruck-Stickstoffatmosphäre erwärmt wird, umfaßt.

8. Verfahren nach einem der Ansprüche 1 bis 4, bei dem die ersten und zweiten Isolierfilme (10, 11) aus Lösungen mit gleicher Feststoffkonzentration gebildet sind und eine kombinierte Dicke im Bereich von 200 bis 400 nm (2000 bis 4000 Å) auf ebenen Oberflächen der zweiten Isolierschicht (4) aufweisen.

**Revendications**

1. Procédé pour fabriquer un dispositif à semiconducteurs comportant un trou de contact (21) qui traverse une couche isolante (9) pour exposer un élément électriquement conducteur (2) et une couche structurée d'un matériau électriquement conducteur disposé sur ladite couche isolante (9) et à l'intérieur du trou de contact (21) pour définir un élément de contact électrique (3) recouvrant le fond et les parois latérales du trou de contact (21) et placé en contact avec ledit élément électriquement conducteur (2), ledit trou de contact (21) étant rempli seulement partiellement par ledit élément de contact électrique (3), les étapes comprenant:

   la formation d'une seconde couche isolante (4) par croissance en phase vapeur sur les parties exposées de ladite première couche isolante (9) et sur ledit élément de contact électrique structurel (3) de manière que ladite seconde couche isolante (4) forme un revêtement au-dessus des parties exposées,

   l'application d'une solution de formation d'un premier film isolant sur la seconde couche isolante (4) par application par rotation de la solution de formation du premier film isolant, et

   le durcissement de la solution de formation du premier film isolant pour former le premier film isolant (10) qui remplit partiellement le reste de la partie non occupée du trou de contact (21) à l'intérieur de ladite seconde couche isolante (4);

   **caractérisé en ce que** ladite solution de formation du premier film isolant possède une première concentration de substances solides choisie de manière à être suffisamment faible pour que le trou de contact (21) soit seulement partiellement rempli par le premier film isolant de sorte qu'aucun vide (7) ne s'y trouve piégé et qu'on applique ensuite une solution de formation d'un second film isolant sur le premier film isolant (10) par application par rotation de la solution de formation du second film isolant pour remplir le reste de la partie non occupée du trou de contact (21) avec un second film isolant (11), ladite solution de formation du second film isolant possédant une seconde concentration de substances solides choisie de manière à être suffisamment faible pour que le trou de contact (21) soit rempli par le second film isolant (11) sans qu'aucun vide (7) n'y soit piégé, mais suffisamment élevée pour qu'aucun renfoncement (8) n'apparaisse dans le second film isolant (11) au-dessus du trou de contact (21);

   on fait durcir la solution de formation du second film isolant pour former le second film isolant (11) recouvrant ledit premier film isolant (10) et définissant une surface sensiblement plane qui s'étend en travers du trou de contact (21); et

   on fait durcir en outre les premier et second films isolants (10, 11) en chauffant le dispositif à semiconducteurs.

2. Procédé selon la revendication 1, **caractérisé en outre en ce qu'**on fait durcir par cuisson la solution de formation du premier film isolant et la solution de formation du second film isolant.

3. Procédé selon l'une quelconque des revendications 1 et 2, **caractérisé en outre en ce que**

   ladite solution de formation du premier film isolant est une solution de verre appliquée par rotation à 9,5 % en poids, et

   ladite solution de formation du second film isolant est une solution de verre appliquée par rotation à 12 % en poids.

4. Procédé selon l'une quelconque des revendications 1 à 3, **caractérisé en outre en ce qu'**on applique la solution de formation du premier film isolant sur la seconde couche isolante (4) au moyen d'étapes successives d'application par rotation incluant l'application par rotation de ladite solution de formation du premier film isolant, à une vitesse

de rotation relativement faible pendant une première étape d'application par rotation sur la seconde couche isolante (4), puis une autre application par rotation de ladite solution de formation du premier film isolant à une vitesse relativement élevée de rotation lors d'une seconde étape d'application par rotation sur la seconde couche isolante (4),

on fait durcir la solution de formation du premier film isolant en soumettant la solution de formation du premier film isolant à une pluralité d'étapes de cuisson à des températures croissantes pour former un premier film isolant (10) qui remplit partiellement le reste de la partie non occupée du trou de contact (21) dans ladite seconde couche isolante (4) recouvrant la surface dudit élément de contact électrique (3) à l'intérieur du trou de contact (21),

on refroidit le premier film isolant (10), on applique ensuite la solution de formation du second film isolant sur le premier film isolant (10) au moyen d'étapes successives d'application par rotation incluant la rotation de ladite solution de formation du second film isolant, à une vitesse de rotation relativement faible pendant une première étape d'application par rotation sur le premier film isolant (10), et ensuite la rotation de ladite solution de formation du second film isolant à une vitesse relativement élevée de rotation pendant une seconde étape d'application par rotation sur le premier film isolant (10) pour achever le remplissage du reste de la partie non occupée du trou de contact (21); et

on fait durcir la solution de formation du second film isolant en soumettant ladite solution de formation du second film isolant à une pluralité d'étapes de cuisson à des températures croissantes pour former un second film isolant (11) recouvrant ledit premier film isolant (10) et définissant une surface sensiblement plane s'étendant sur le trou de contact (21) au-dessus de la partie supérieure de ce dernier.

**5.** Procédé selon la revendication 4, **caractérisé en outre en ce que** ladite première étape d'application par rotation utilisée lors de l'application de chacune desdites solutions de formation des premier et second films isolants est exécutée à une vitesse de 700 tr/mn pendant environ une seconde; et

ladite second étape d'application par rotation servant à appliquer chacune desdites solutions de formation des premier et second films isolants est exécutée à une vitesse de 4000 tr/mn pendant environ 30 secondes.

**6.** Procédé selon l'une ou l'autre des revendications 4 ou 5, **caractérisé en outre en ce que** ladite pluralité d'étapes de cuisson, auxquelles chacune desdites solutions de formation des premier et second films isolants sont soumises inclut les étapes respectives de cuisson d'une durée de deux minutes, chacune à des températures de 100°C, 180°C et 260°C.

**7.** Procédé selon l'une quelconque des revendications 4 à 6, **caractérisé en outre en ce que** l'étape de durcissement supplémentaire des premier et second films isolants (10, 11) soumet ledit premier film isolant (10) et ledit second film isolant (11) à l'action d'une chaleur maintenue pendant un intervalle de temps étendu, et inclut une première phase avec application d'une chaleur à 250°C pendant 30 minutes, suivie par une seconde phase avec application d'une chaleur à 400°C pendant 60 minutes, dans une atmosphère d'azote à basse pression.

**8.** Procédé selon l'une quelconque des revendications 1 à 4, selon lequel lesdits premier et second films isolants (10, 11) sont formés de solutions possédant les mêmes concentrations en substances solides et possède une épaisseur combinée dans la gamme entre 200 et 400 mn (2000 à 4000 Å) sur des surfaces planes de ladite seconde couche isolante (4).

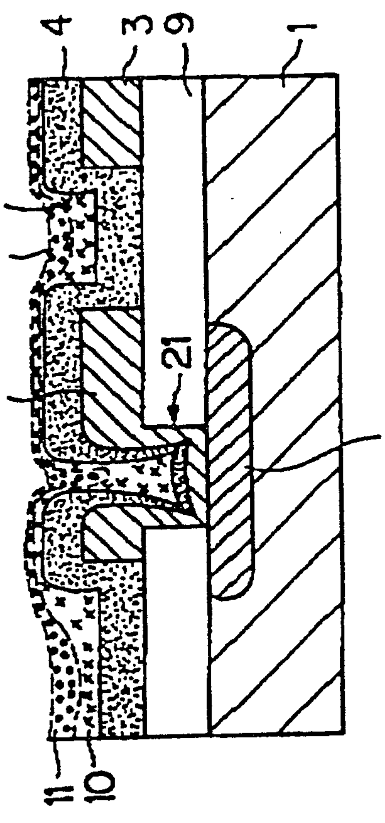


Fig. 1

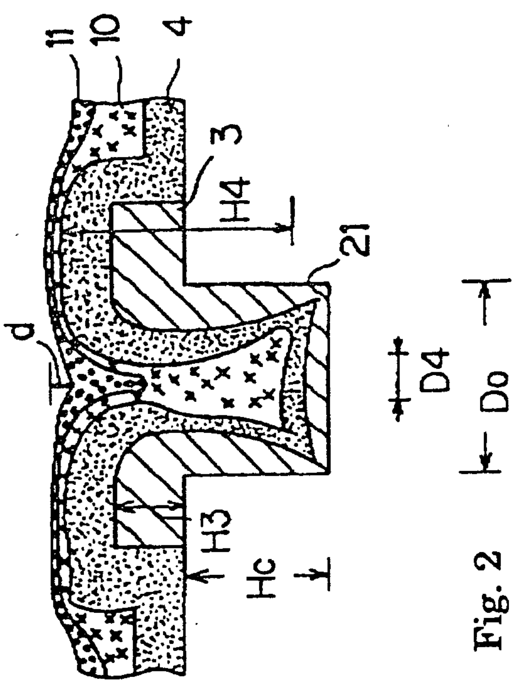


Fig. 2

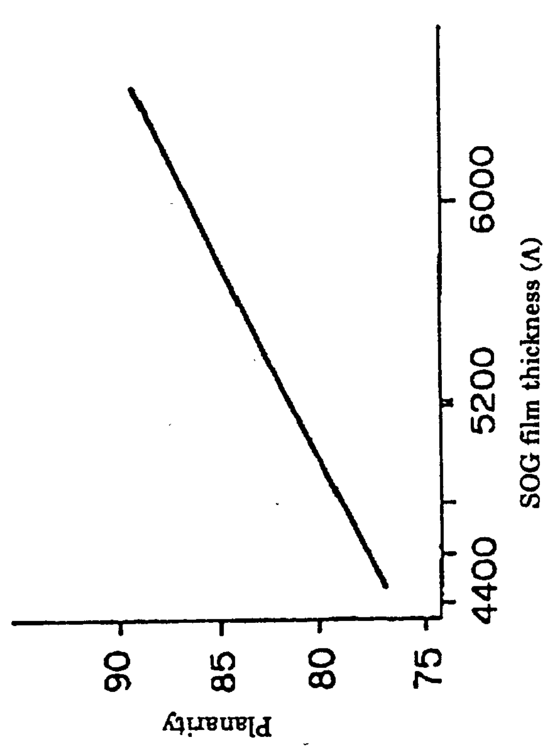


Fig. 3

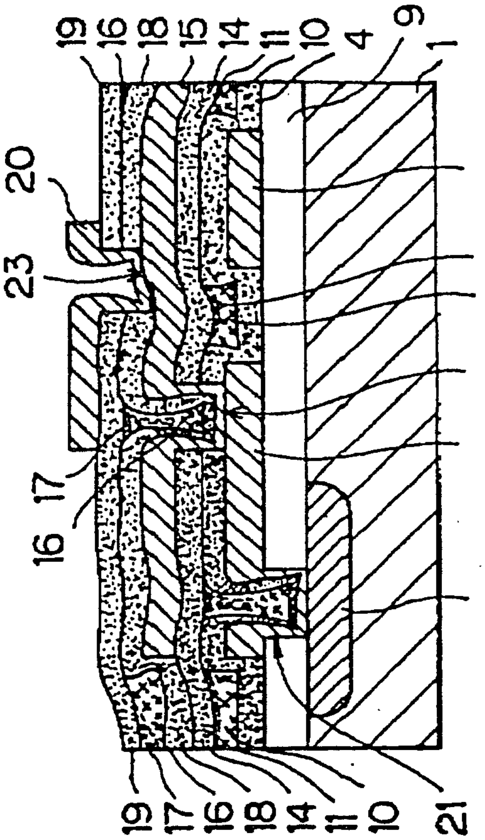


Fig. 4

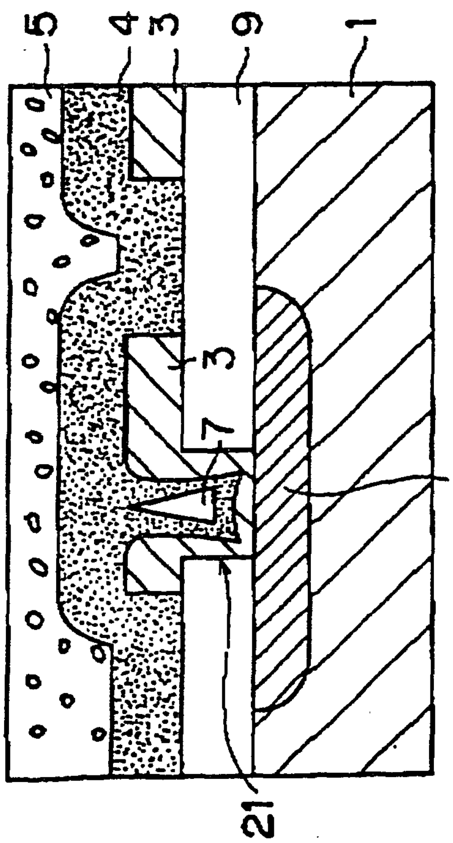


Fig. 5a

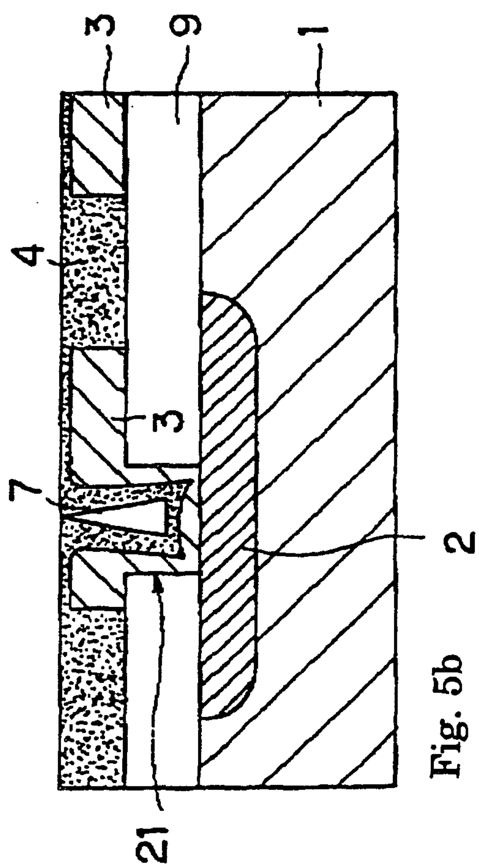


Fig. 5b

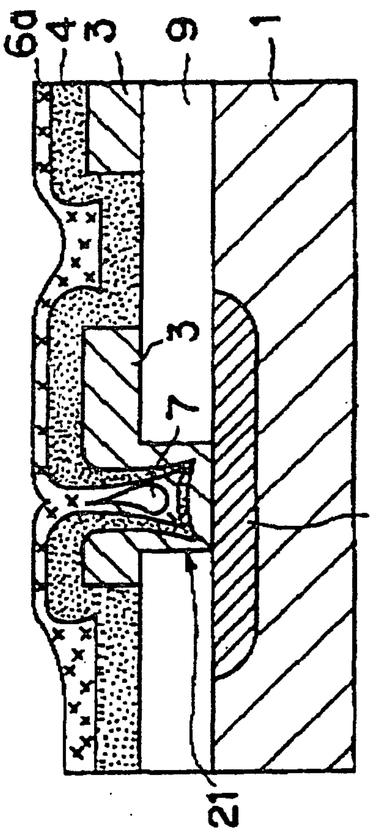


Fig. 6a

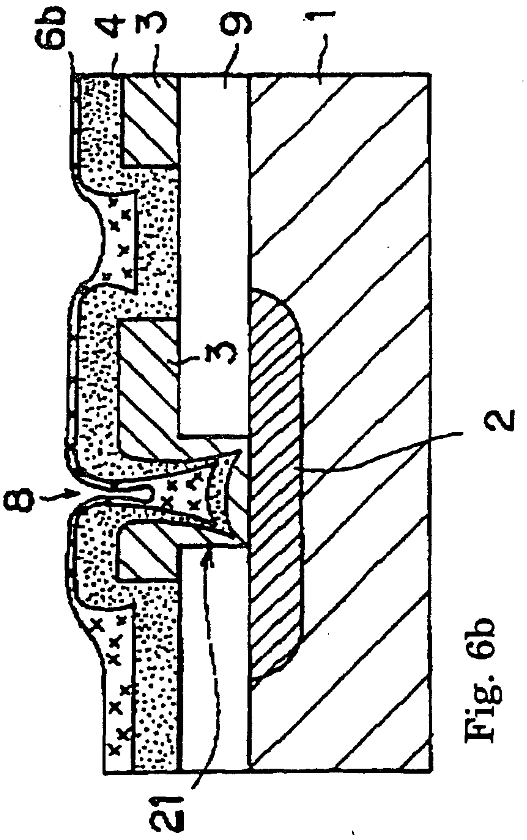


Fig. 6b